(19) Europäisches Patentamt
European Patent Office
Office européen des brevets

(11) **EP 0 827 097 A2**

(12) **EUROPEAN PATENT APPLICATION**

(43) Date of publication:
04.03.1998 Bulletin 1998/10

(51) Int. Cl.$^6$: **G06F 17/50**

(21) Application number: 97114762.4

(22) Date of filing: 26.08.1997

(84) Designated Contracting States:
AT BE CH DE DK ES FI FR GB GR IE IT LI LU MC NL PT SE
Designated Extension States:
AL LT LV RO SI

(30) Priority: 26.08.1996 JP 223994/96

(71) Applicant:
KABUSHIKı KAISHA TOSHIBA
Kawasaki-shi, Kanagawa-ken 210 (JP)

(72) Inventors:
• Kotani, Hiroko
  Tokyo (JP)
• Usami, Kimiyoshi
  Yokohama-shi, Kanagawa-ken (JP)
• Nishio, Seiichi
  Yokohama-shi, Kanagawa-ken (JP)

(74) Representative:
Zangs, Rainer E., Dipl.-Ing. et al
Hoffmann Eitle,
Patent- und Rechtsanwälte,
Arabellastrasse 4
81925 München (DE)

(54) **Low power consumption circuit design method**

(57)    In a low power consumption circuit design method, a timing analysis (Step S101) of a logic circuit is performed and a delay time of a cell in a path having a timing slack detected by the timing analysis is calculated when it is replaced with a cell of a low voltage power source (Step S108). When this replacement satisfies the timing constraints, the cell is replaced with the cell of the low voltage power source (Step S110). A cell in a path having no timing slack detected by the timing analysis is replaced with a cell having a higher driving ability (Step S115). When this replacement of the cell satisfies the timing constraints, the cell is replaced with a cell being operable under the lower voltage power source (Step S110).

FIG.1

**Description**

BACKGROUND OF THE INVENTION

1. Field of the Invention

The present invention relates to a low power consumption circuit design method, and more particularly, it relates to a low power consumption circuit design method to reduce the power consumption of a CMOS circuit incorporated in a LSI (Large Scale Integration).

2. Description of the Related Art

Recently, a power consumption of a semiconductor integrated circuit has been rapidly increased. For example, there are some processor chips in MPU (Microprocessor unit) and DSP (digital Signal Processing) whose power consumption is approximately more than several Watts.

When the power consumption of a semiconductor chip is more than several watts, it is difficult to contain it in a plastic package. It causes thereby to increase the cost of packaging and cooling. Recently, since movable devices such as portable telephone devices and the like are the object of public attention all over the world and widely used, it is required to reduce a power consumption of a semiconductor chip so that the movable devices using a battery can be performed for a long time. Therefore it becomes the important problem to reduce a power consumption of a LSI.

There are various technical approaches to reduce a power consumption of a CMOS circuit, for example, to reduce a load capacity and a switching activity. In general, because the power consumption is in proportion to the square of the voltage supply (hereinafter refer to as a VDD), it is more effective to reduce the VDD. However, when the VDD is decreased, the delay time of operation in a circuit is increased and the processing performance of the LSI is also decreased because the magnitude of a drain current in transistors is decreased.

In conventional techniques, there are various methods in order to maintain the processing performance of the LSI. For example, there is a conventional technique to maintain the performance of a LSI in which a plurality of power sources are used and the VDD corresponding to a circuit part in the LSI that satisfies timing constraints is reduced.

Because each signal path has a some different signal propagation delay, it is possible to reduce the level of a VDD for a path having a timing slack without reducing the total performance of the LSI. In this case, however, it must be required to place a level converter LC to prevent a DC current at an interface section between a cell that operates in a lower power voltage source and a cell that operates a higher power voltage source. This causes that this level converter LC circuit requires a large dynamic power when switching. Therefore it is required to minimize the number of the level converters LC in a LSI by reducing the VDD for grouped circuits.

There is the conventional technique held by International Symposium on Low Power Design (ISLPD' 95) in April, 1995:

[1] K.Usami and M.Horowitz, "Clustered Voltage Scaling Technique for Low-Power Design", Proc. pp.3-8.

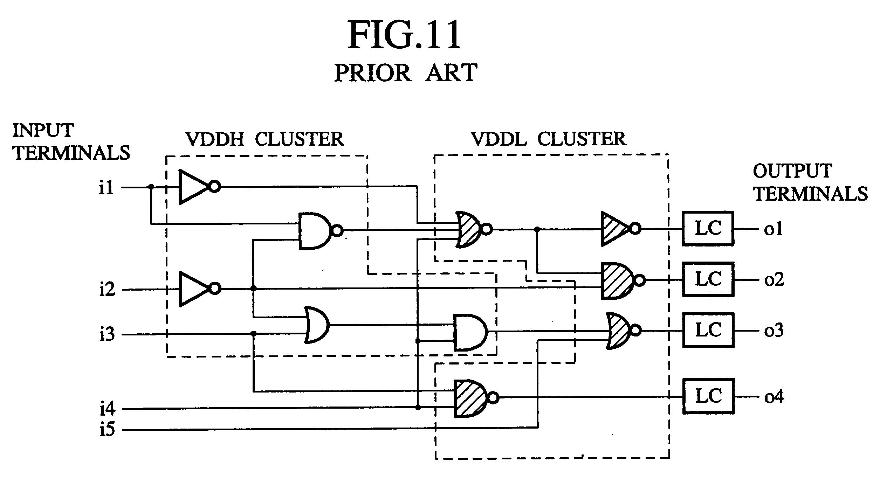

In this literature, as shown in FIG.11, a VDDH cluster and a VDDL cluster in a logic circuit are formed. The VDDH cluster comprises cells driven by the voltage of a high power source VDDH placed close to the input pins i1, i2, ..., i5 of the logic circuit. The VDDL cluster comprises cells driven by the voltage of a low power source VDDL placed close to the output pins o1, o2, ..., o4 of the logic circuit. In this logic circuit configuration, it is possible to reduce the power consumption because it can be achieved to save the number of level converters LC up to the number of the output pins as the maximum number.

However, because the method in the conventional technique [1] described above is applied only to cells that are not in a critical path, it is difficult to apply this method to circuits having a strict timing. In general, the delay time, that is designated by the reference character "Delay VDDL", when cells are switched from a high voltage power source to a low voltage power source is defined by the following equation:

$$\text{Delay VDDL} = (\text{VDDL}/(\text{VDDL} - \text{Vth})^2) \cdot ((\text{VDDH} - \text{Vth})^2/\text{VDDH}) \cdot \text{Delay VDDH} \qquad \text{(Equation 1)},$$

where VDDH is the high voltage power source in original cells, VDDL is the low voltage power source in the original cells, and Vth is a threshold voltage.

Thus, because the magnitude of the delay VDDL is increased according to the above equation, the delay time can be decreased approximately 2.2 times when the threshold voltage is 0.8 V and the voltage power source is changed from 5V (High voltage level) to 3V (Low voltage level). Accordingly, the more strictly the timing condition, the lower possibility to switch the low voltage power source. Thus, there is a problem that it is difficult to reduce the power consumption of cells effectively. In addition to this, although the low power design method in which cells are replaced is applied to the logical synthesis method and a gate re-sizing method, this method is used only in the timing constraints. Therefore there is the effect that no effect can be expected when this method is applied to circuits having strict timing constraints.

## SUMMARY OF THE INVENTION

Accordingly, an object of the present invention is, with due consideration to the drawbacks of the conventional low power circuit design method, to provide a low power circuit design method that is capable of reducing a power consumption of a LSI by replacing a target cell (this target cell can not be replaced with a lower power voltage cell and this target cell can not be a cell of the target of a gate resizing operation because it does not satisfy timing constraints before the low power circuit design method of the present invention is applied to the cell) with a cell that is operable under a lower voltage power source.

In accordance with a preferred embodiment of the present invention, a low power consumption circuit design method for a LSI comprising logic circuits including cells that operate under at least two different voltage power sources, comprising the steps of, a timing analysis step of performing a timing analysis for the cells in the logic circuits in the LSI, a conversion step of converting an optional cell in the cells into a cell having a different driving ability, and a replacement step of replacing the optional cell with a cell that operates under a different voltage power source.

In the low power consumption circuit design method as another preferred embodiment of the present invention, the timing analysis step comprises, an extraction step of extracting a path in the logic circuits in which there is no timing slack in timing, the conversion step comprises, a step of replacing the optional cell with a cell having an equivalent function and a higher driving ability, and the low power consumption circuit design method further comprises, a step of converting the optional cell with a cell that satisfies required timing constraints and operates under a lower voltage power source.

In the low power consumption circuit design method as another preferred embodiment of the present invention, in the step of extracting the path having no timing slack and in the step of replacing the optional cell with cell having the different driving ability in the timing analysis step, the optional cell is replacing with a cell, having the equivalent function and a higher driving ability, that is operable under a lower voltage power source within satisfying of the timing constraints.

In the low power consumption circuit design method as another preferred embodiment of the present invention, the step of replacing the optional cell with a cell having the different driving ability in the timing analysis step further comprises a step of replacing the optional cell with a cell having a smaller driving ability.

In the low power consumption circuit design method as another preferred embodiment of the present invention in the step of replacing the optional cell with the cell having the different driving ability, the optional cell is replacing with a cell having an equivalent function and a higher driving ability, and then replacing it with a cell that is operable under a lower voltage power source, and in the step of replacing the optional cell with the cell having the different driving ability with keeping of the timing constraints in accordance with a result of the timing analysis step, the optional cell is replacing with a cell having a lower driving ability.

In accordance with another preferred embodiment of the present invention, a low power consumption circuit design method for a LSI comprising logic circuits including cells that operate under at least two different voltage power sources, comprising the steps of, a timing analysis step of performing a timing analysis for the logic circuits in the LSI, a step of obtaining a delay time for a cell connected to a path having a timing slack in the logic circuits in accordance with a result of the timing analysis step, and of replacing the cell with a cell that is operable under a lower voltage power source only when this replaced cell satisfies timing constraints, and a step of replacing a cell connected to a path having no timing slack with a cell having an equivalent function and a higher driving ability in accordance with a result of the timing analysis step, and of further replacing the cell with a cell that is operable under the lower voltage power source when this replacement satisfies the timing constraints.

In accordance with another preferred embodiment of the present invention, a low power consumption circuit design method for a LSI comprising logic circuits including cells that operate under at least two different voltages power sources, comprising the steps of, a timing analysis step of performing a timing analysis for the logic circuits in the LSI, a step of obtaining a delay time for a cell connected to a path having a timing slack in the logic circuits in accordance with a result of the timing analysis step, and of replacing the cell with a cell that is operable under a lower voltage power source only when this replaced cell satisfies timing constraints, a step of replacing a cell connected to a path having no timing slack with a cell having an equivalent function and a higher driving ability in accordance with a result of the timing analysis step, and of replacing the cell with a cell that is operable under the lower voltage power source when this replacement satisfies the timing constraints, and a step of replacing the cell, connected to the path having a timing slack in accordance with the result of the timing analysis step, with a cell having the equivalent function and a higher driving ability when the replacement of this cell with the cell being operable under the lower voltage power source does not satisfy the timing constraints, and of further replacing this cell with a cell that is operable under the lower voltage power source when this replacement satisfies the timing constraints.

In the low power consumption circuit design method as another preferred embodiment of the present invention, when it does not satisfy the timing constraints that the cell connected to the path having the timing slack in the logic circuits is replaced with the cell that being operable under the lower voltage power source in accordance with the result of the timing analysis step, further comprises the steps of: a step of searching whether or not there is a cell having the equivalent function and a higher driving ability for the cell that has already been replaced with the cell that being operable under the lower voltage power source, a step of replacing the searched cell with a cell having the equivalent function and the higher driving ability, and a step of further replacing the replaced cell with a cell that being operable under the lower voltage power source when this replacement satisfies the timing constraints.

BRIEF DESCRIPTION OF THE DRAWINGS

These and other objects, features, aspects and advantages of the present invention will become more apparent from the following detailed description of the present invention when taken in conjunction with the accompanying drawings, in which:

FIG.1 is a diagram showing a flow chart of a process of a low power consumption circuit design method according to the first embodiment of the present invention.

FIG.2 is a diagram showing an example of a logic circuit used for explaining a process of s a low power consumption circuit design method according to each embodiment of the present invention.

FIG.3 is a diagram showing an example of a cell library used for the logic circuit shown in FIG.2.

FIG.4 is a diagram showing changes of timing slacks when cells in a logic circuit are used in a low voltage power source.

FIG.5 is a diagram showing a flow chart of the process of a low power consumption circuit design method according to the second embodiment of the present invention.

FIG.6 is a diagram showing an example of a logic circuit used for explaining a process of the low power consumption circuit design method according to the third embodiment of the present invention.

FIG.7 is a diagram showing an example of a cell library used for the logic circuit shown in FIG.6.

FIG.8 is a diagram showing an example of a cell library used for the logic circuit shown in FIG.6.

FIG.9 is a diagram showing a flow chart of the process of a low power consumption circuit design method according to the fourth embodiment of the present invention.

FIG.10 is a diagram showing a flow chart of the process of a low power consumption circuit design method according to the fifth embodiment of the present invention.

FIG.11 is a circuit diagram having two clustered voltage power sources, VDDL cluster and VDDH cluster.

DESCRIPTION OF THE PREFERRED EMBODIMENTS

Other features of this invention will become apparent through the following description of preferred embodiments which are given for illustration of the invention and are not intended to be limiting thereof.

Preferred embodiments of a low power consumption circuit design method according to the present invention will now be described with reference to the drawings.

First embodiment

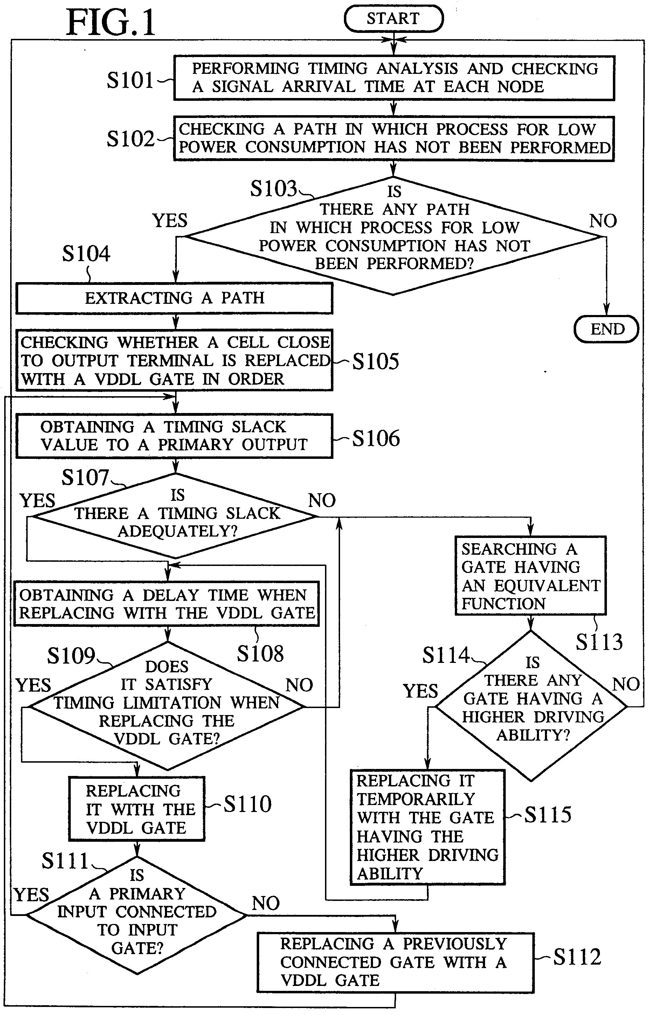

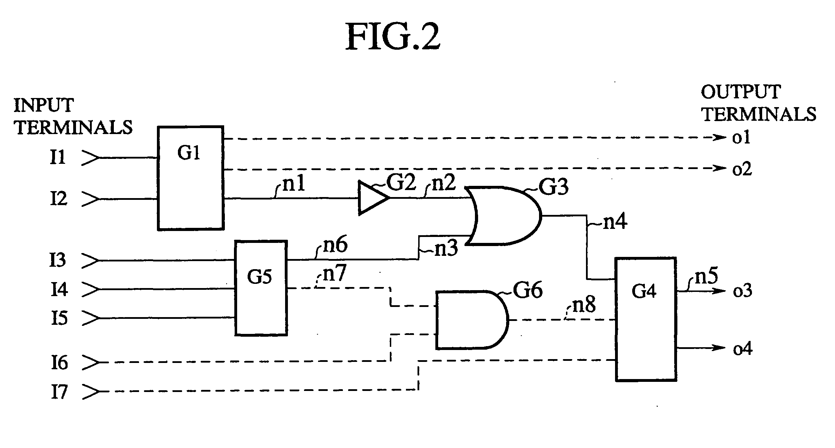

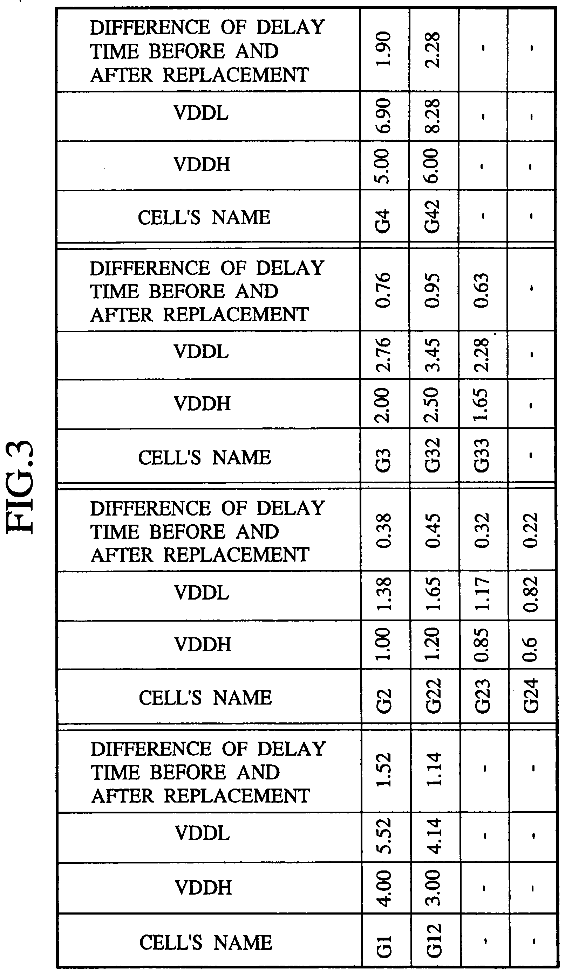

FIG.1 is a diagram showing a flow chart of a process of a low power consumption circuit design method for logic circuit according to the first embodiment of the present invention. FIG.2 is a diagram showing an example of a logic circuit used for explaining a process of the low power consumption circuit design method for logic circuits according to each embodiment of the present invention. FIG.3 is a diagram showing an example of a library of cells used in the logic circuit shown in FIG.2.

Hereinafter, a process of the logic circuit design method as the first embodiment will be explained with reference to the logic circuits shown in FIG.2 and the library of cell data items shown in FIG.3.

Firstly, in the logic circuit shown in FIG.2, a signal arrival time from input terminals i1 and i2 to output terminals o3 and o4 is 12.00 ns. Its timing constraint is 15.00 ns. Therefore we assume that there is a timing slack of 3.0 ns. In addition, in order to calculate it simply, the delay time is defined by using the sum of the total time counted from a signal input time to a signal output time in each cell in a logic circuit. The voltage of the high voltage power source VDDH is 5 V and the voltage of the low voltage power source VDDL is 4 V. The value Vth of threshold voltage is 0.8 V.

In general, the delay time is calculated by using the equation [1] that has been explained previously when a cell operating in the high voltage power source VDDH (hereinafter referred to as a VDDH cell) is replaced to a cell operating in the low voltage power source VDDL (hereinafter referred to as a VDDL cell). Accordingly, when it is replaced with a VDDL cell, the delay time becomes as follows:

$$\text{Delay VDDL} = (VDDL / (VDDL - Vth)^2) \cdot ((VDDH - Vth)^2 / VDDH) \cdot \text{Delay VDDH} \qquad \text{(Equation 2)}.$$
$$= (4/(4-0.8)^2) \cdot ((5-0.8)^2/5) \cdot \text{Delay VDDH}$$
$$= 1.38 \text{ Delay VDDH}$$

This result shows that the delay time of the VDDL cell is approximately 1.38 times of that of VDDH cell.

First, the signal arrival time of a signal at each node is confirmed by using a timing analysis of the logic circuit shown in FIG.2 (Step S101). Following, paths having cells that have not been replaced with VDDL cells are checked (Step S102). Then, unprocessed paths are extracted (Step S103 and Step S104).

In the first embodiment, first, the replacement to VDDL cells for the path having G1 to G4 cells will be executed. Here, in order to reduce the number of level converters required for voltage circuits of a plural power sources, the conventional technique disclosed in the reference [1] is used. Thereby, a cluster having cells close to the input terminals and also close to the output terminals that can be driven by the high voltage power source VDDH and the low voltage power source VDDL is formed. Then, in order to reduce the voltage, the cells are replaced with VDDL cells from the output terminals to the input terminals in order (Step S105). Accordingly, the cell close to the output terminals o3 and o4 is replaced with the VDDL cell in order.

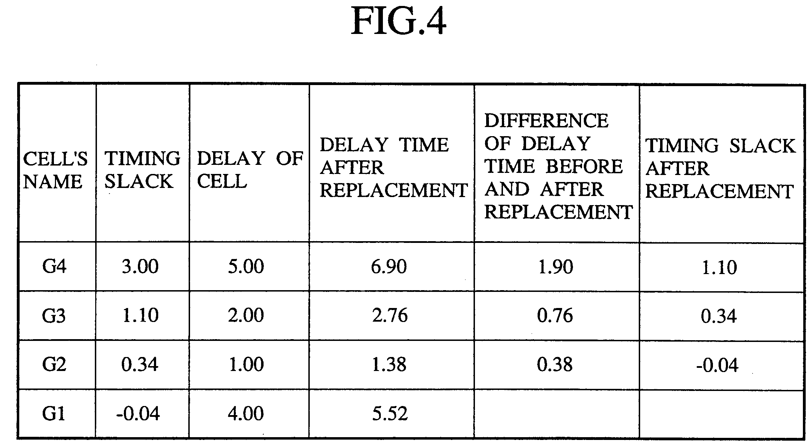

Firstly, the signal arrival time to the node n5 is detected. This signal arrival time is 12.00 ns. Accordingly, it has the timing slack of 3.0 ns (Step S106). Because it has a longer timing slack considerably, the delay time is obtained when the cell G4 is replaced with the VDDL cell (Step S107 and Step S108). It is seen that the timing constraints can be satisfied even if the cell G4 is replaced with the VDDL cell because the total delay time is increased only by 1.90 ns and the timing slack is 3.00 ns (Step S109), as shown in FIG.4. Therefore, the cell G4 is replaced with the VDDL cell (Step S110).

Next, it is detected whether the cell G3 can be replaced with the VDDL cell or not because the cell G3 connected to the cell G4 is not the input cell. When the cell G3 is replaced with the VDDL cell, the timing slack at the node n4 becomes 1.10 ns (3.00 ns - 1.90 ns = 1.10 ns) (Step S106). Therefore the delay time is calculated when the cell G3 is replaced with the VDDL cell because it has the timing slack adequately (Step S107 and Step S108). The delay time is increased by 1.76 ns ((2.00 × 1.38 ns) - 2.00 ns = 1.76 ns) when the cell G3 is replaced with the VDDL cell. Because the total timing slack is now 1.10 ns, it has the timing slack of 0.34 ns even if the cell G3 is replaced with the VDDL cell. Therefore the cell G3 can be replaced with the VDDL cell (Step S110).

Next, the replacement of the cell G2 is performed because a cell connected to the cell G3 is not an input cell (Step S111 and Step S112).

Although the total timing slack to the node n2 becomes 0.34 ns when the cell G3 is replaced with the VDDL cell (Step S106), there is the timing slack adequately. Accordingly, the delay time is calculated when the cell G2 is replaced with the VDDL cell (Step S107 and Step S108). It is difficult in timing to replace the cell G2 with the VDDL cell because the delay time is increased by 0.38 ns when the cell G2 is replaced with the VDDL cell.

In order to save the increased delay time less than 0.34 ns, it is acceptable that the cell G2 is replaced with the cell whose transfer delay time is 0.89 ns or less. Accordingly, it is possible to replace the cell G2 with a cell whose driving ability is higher than the cell G2 and whose transfer delay (or a propagation delay) is 0.89 ns or less. It is searched whether or not there is a cell whose function is the same as that of the cell G2 and whose driving ability is higher than that of the cell G2 (Step S113).

As shown in FIG.3, there are four types of cells G2, G22, G23, and G24 whose function is the same as that of the cell G2.

Because the delay time of the cell G22 is 1.20 ns, it is impossible to replace this cell G22 with the VDDL cell. However, it is possible to replace the cells G23 and G24 with the VDDL cell and the cell G23 and G24 satisfy the timing constraints. Accordingly, the cell G2 can be replaced with a proper cell according to the area of the cell and other constraints conditions (Step S114 and S115).

For example, the cell G3 is replaced with the cell G24 and it is also replaced with the VDDL cell (stet S108 and Step S110). The timing slack value is changed to 0.04 ns when the cell G24 is replaced with the VDDL cell for the cell G1 (Step S107). Although there is the timing slack adequately, the delay time is increased by 1.52 ns when the cell G1 is replaced with the VDDL cell. In this case, it is impossible to satisfy the timing constraints. Therefore it can be understood that it is impossible to replace the cell G1 with the VDDL cell (Step S108 and Step S109).

Next, it is searched whether or not there is a cell whose function is the same as that of the cell G1 and whose driving ability is higher than that of the cell G1 (Step S108 and Step S109). It is difficult to satisfy the timing constraints because the timing slack value becomes -1.0 ns even if the cell G1 is replaced with the cell G12 whose driving ability is higher than that of the cell G1 in order to decrease the voltage power source. That is, the path comprising the cells G1, G2, G3, and G4 has no chance to reduce the voltage power source because it is difficult to replace the cell G1 with the VDDL cell. Therefore, the process is shifted to other paths in order to reduce the voltage power source and the same processing described above will be repeated. These process is executed for all of the paths in the logic circuit and the process of the low power consumption circuit design method is completed.

Second embodiment

In the first embodiment, it is difficult to replace the cell G1 with any VDDL cell whose function is the same as that of the cell G1. However, it is possible to replace many cells with the VDDL cells when the cell G3 is replaced with the cell G33 whose driving ability is higher than that of the cell G3 and then replaced with the VDDL cell.

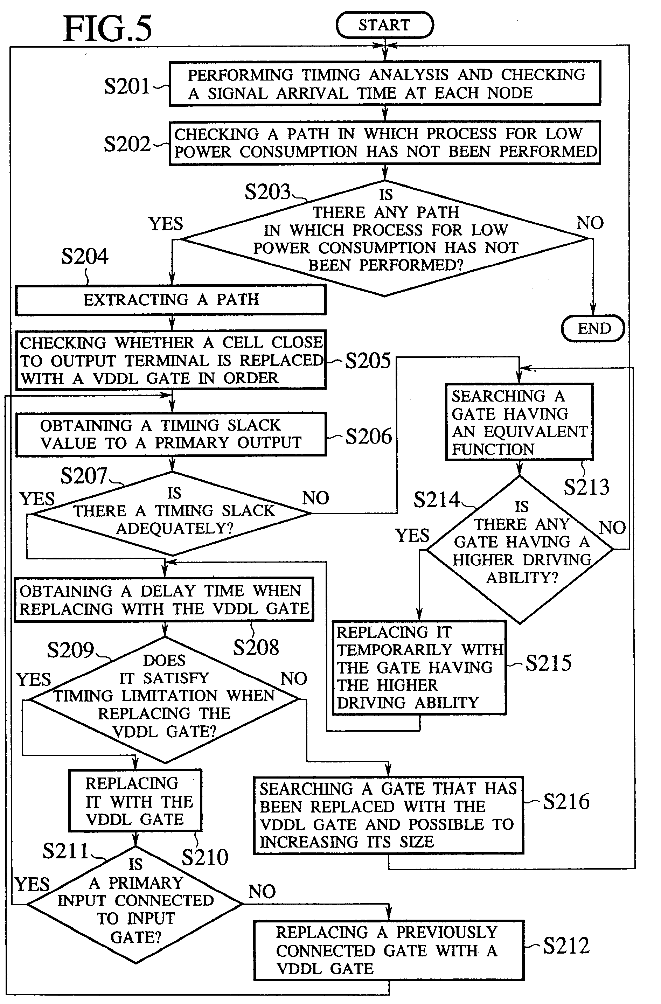

FIG.5 is a diagram showing a flow chart of the process of a low power consumption circuit design method for logic circuits according to the second embodiment of the present invention. In the following explanation of the second embodiment, the condition of the timing constraints that is the same as that used in the first embodiment will also be used. That is, we assume that the signal arrival time from the input terminal i1 to i7 to the output terminals o1 to o4 is 12.00 ns and the timing constraints is 15.00 ns and the timing slack is 3.00 ns in the logic circuit shown in FIG.2. In addition, in order to calculate a delay time easily, the delay time is the sum of the signal input time to the output time in each cell. The high voltage power source VDDH is 5.0 V and the low voltage power source VDDL is 4.0 V, and the threshold voltage Vth is 0.8 V.

Firstly, the timing analysis for the logic circuit shown in FIG.2 is performed and the low power consumption circuit design method of the second embodiment is applied to the path comprising the cells G1, G2, G3, and G4 in order to reduce the power consumption of this path (Step S201 to Step S204).

Like the first embodiment, clusters in which cells driven by the low voltage VDDL and by the high voltage VDDH, respectively, are grouped in order to decrease the number of the level converters in the second embodiment by using the conventional technique [1]. That is, a cell closed to the output terminals is replaced firstly with the VDDL cell in order to reduce the voltage power source (Step S205). Accordingly, the signal arrival time from the input terminal to the node G4 becomes 12.00 ns and the timing slack is 3.00 ns (Step S206).

The delay time is calculated when the cell G4 is replaced with the VDDL cell because there is the timing slack adequately (Step S207 and Step S208). When the cell G4 is replaced with the VDDL cell, the delay time is increased by 1.90 ns. Therefore it is seen to satisfy the timing constraints even if the cell G4 is replaced with the VDDL cell because the timing slack is 3.00 ns (Step S209). Thereby, the cell G4 is replaced with the VDDL cell (Step S210).

Because the cell connected to the cell G4 is not an input cell, it is checked whether or not the cell G3 can be replaced with the VDDL cell (Step S211 and S212). The timing slack at the node G4 is 1.10 ns (3.00 - 1.90 = 1.10 ns) when the cell G4 is replaced with the VDDL cell (Step S206). Because there is the time slack adequately, the delay time is calculated when the cell G3 is replaced with the VDDL cell (Step S207 and Step S208).

The delay time is increased by 0.27 ns ((2.00 × 1.38) - 2.00 = 0.76 ns) when the cell G3 is replaced with the VDDL cell. Now, because the timing slack value is 1.00 ns, there is the timing slack adequately even if the cell G3 is replaced with the VDDL cell (Step S209). Thereby, the cell G3 can be replaced with the VDDL cell (Step S210).

Next, it is performed to replace the cell G2 with the VDDL cell because the cell G2 connected to the cell G3 is not an input cell (Step S211 and Step S212).

Although the timing slack value to the node n2 is decreased to 0.34 ns by replacing the cell G3 with the VDDL cell (Step S206), the delay time is calculated when the cell G2 is replaced with the VDDL cell because there is the timing slack value adequately (Step S207 and Step S208). However, it is impossible in timing to replace the cell G2 with the VDDL cell because the delay time is increased by 0.387 ns when it is replaced with the VDDL cell (Step S209).

In order to decrease the delay time up to 0.34 ns, it must be satisfied to take the transfer delay time of the cell G2 approximately 0.89 ns or less. Accordingly, it is possible to replace the cell G2 with the VDDL cell whose function is the same as that of the cell G2 and whose driving ability is higher than that of the cell G2 and whose signal transfer delay is not less than 0.89 ns, without timing constraints. Therefore it is checked whether or not there is any cell whose function is the same as that of the cell G2 and whose driving ability is higher than that of the cell G2 (Step S213). As shown in FIG.3, there are four cells G2, G22, G23, and G24 that satisfy these conditions. Although it is difficult to replace the cell G2 with the cell G22 because the delay time of the cell G22 is 1.20 ns, it is possible to replace it with one of the cells G23 and G24 because they satisfy the timing condition adequately. It is thereby possible to replace the cell G2 with one of the G23 and G24 according to other conditions such as area, and the like (Step S241 and Step S215). For example, the cell G2 is replaced with the cell G24 and then it is replaced with the VDDL cell (Steps S208 to S210).

Next, the process will be executed for the cell G1. The timing slack value is changed to 0.04 ns when the cell G24 is replaced with the VDDL cell (Step S210). Although there is the timing slack adequately, the delay time is increased by 1.52 ns when the cell G1 is replaced with the VDDL cell. Because this case does not satisfy the timing constraints, it is impossible to replace the cell G1 with the VDDL cell (Step S208 and Step S209).

Next, it is searched whether or not there is any cell whose function is the same as that of the cell G1 and whose driving ability is higher that of the cell G1 (Step S208 and Step S209).

Because the timing slack value becomes -1.00 ns when the cell G1 is replaced with the cell G12 whose driving ability is higher than that of the cell G1. The cell G12 does not satisfy the timing constraints. That is, it is impossible to replace the cell G1 with the VDDL cell. This means that it is difficult to change the path to the low voltage power source in addition to this state.

Next, it is performed to search there is any cell that has already been replaced with the VDDL cell and that can be performed by up-sizing (Step S214 and Step S215). Because the cell G2 has been replaced with the cell G24 having the highest driving ability, it is difficult to perform the up-sizing for the cell G2 any more.

Next, it is checked whether or not the operation of up-sizing can be performed for the cell G3. As shown in FIG.3, there is the cell G33 whose driving ability is higher than that of the cell G3. When the cell G3 is replaced with the cell G3 for up-sizing, it is possible to reduce the delay time by 0.48 ns than the case that the cell G3 is replaced with the VDDL cell. That is, even if the path is formed by the cell G12--> the cell G24 --> the cell G33 --> the cell G4 and each cell is replaced with the VDDL cell, the total delay time becomes 14.92 ns. This value satisfy the timing constraints adequately.

Accordingly, the cell G3 is replaced with the cell G33 and the cell G1 is replaced with the VDDL cell (Steps S251 to S211). Because the cell G1 is connected to the input terminal as the input gate (Step S211), the same operation will be performed for the path comprising the cell G5 --> the cell G6 --> (the cell G4) that have not been replaced with the VDDL cell.

The operation of the low power consumption circuit design method of the second embodiment is completed when these processes described above have been performed for all of the paths in the logic circuit.

Third embodiment

Next, a description will now be given of the process of the low power consumption circuit design method of the present invention in detail.

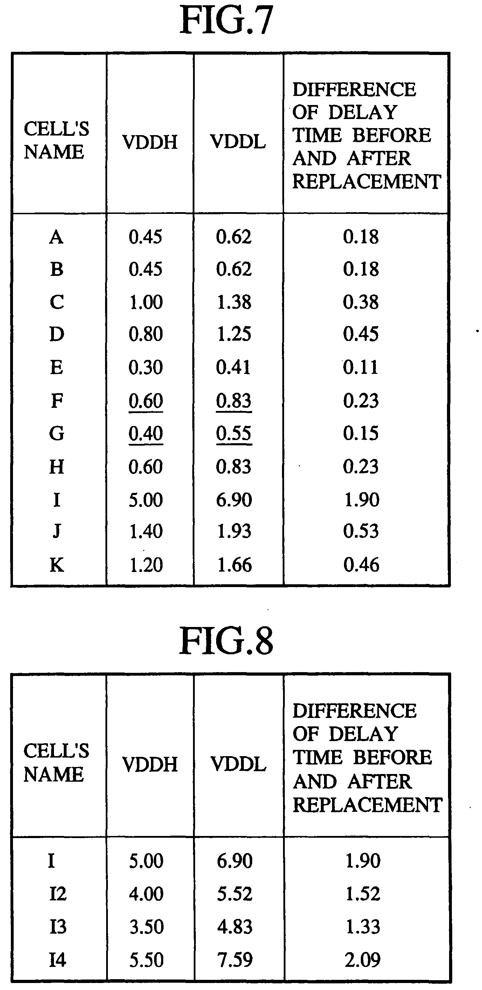

In the explanation of the processing flow of the third embodiment of the present invention, the logic circuit shown in FIG.3 and the cell data item in the cell library shown in FIGs.7 and 8 are used.

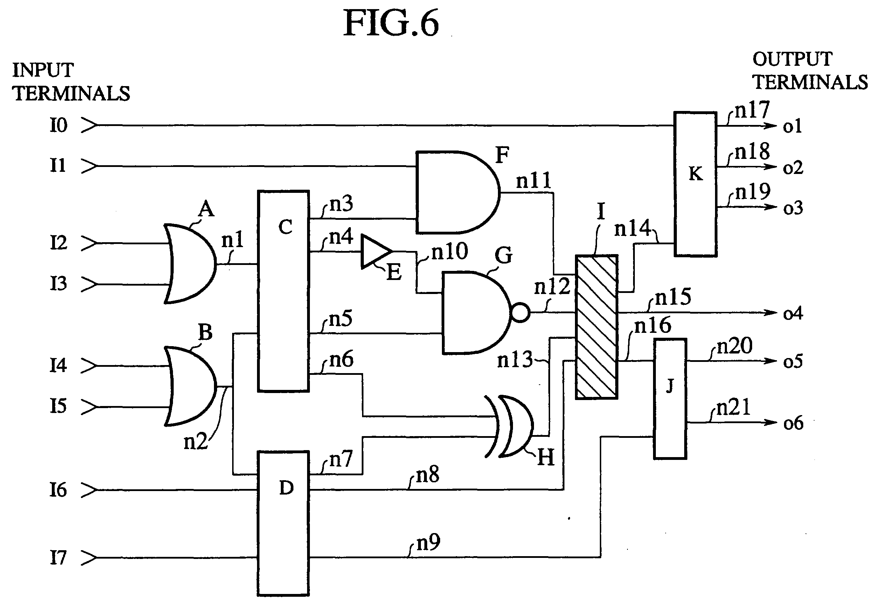

FIG.6 is a diagram showing an example of a logic circuit used for explaining a process of the low power consumption circuit design method for logic circuits according to the third embodiment of the present invention.

At first, the timing analysis for the circuit shown in FIG.6 is performed to confirm the signal arrival time at each node (Step S101).

The operation result of the Step S101 is as follows: the path comprising the cell A --> the cell C --> the cell E --> the cell G --> the cell I --> and --> the cell J becomes the critical path and the delay time of the path is 8.35 ns. Because the timing constraints is 10.00 ns, the timing slack value becomes 1.65 ns.

Next, it is confirmed whether or not there is any path that has not been executed by the low power consumption circuit design method (Step S102 and Step S103). In this case, although any path can be selected because no processing is executed, at first, the critical path comprising the cell A the cell C --> the cell E --> the cell G --> the cell I --> and --> the cell J is selected (Step S104).

Because the third embodiment has the configuration in which the VDDL cell cluster at the output terminal side and the VDDH cell cluster at the input terminal side, the cell close to the output terminal is replaced with the VDDL cell at first.

Firstly, the timing slack value is 1.65 ns because the signal arrival time to the node n20 is 8.35 ns (Step S106).

Since there is the timing slack at the node n20 adequately, the delay time is calculated when the cell J is replaced with the VDDL cell (Step S107 and Step S108).

As shown in FIG.7, although the delay time of the node n16 to the node n20 is changed from 1.40 ns to 1.93 ns, the timing slack value becomes 1.12 ns ((1.65 - (1.93 - 1.40)). This means that the timing constraints can be satisfied when the cell J is replaced with the VDDL cell (Step S111).

Because the cell J is not connected to the input terminal as one of the input pins I0 to I7, the cell I close to the input terminal by one is replaced with the VDDL cell (Step S112).

According to the result of the timing analysis, the timing slack value at the node n16 is 1.12 ns (Step S106). Because there is the timing slack adequately, the time delay is calculated when the cell I is replaced with the VDDL cell (Step S107 and Step S108). According to the table shown in FIG.7, when the cell I is replaced with the VDDL cell, the delay time of the node n12 to the node n15 is increased by 1.90 ns. Thereby, it is difficult to satisfy the timing constraints because the total delay time in the path becomes 10.78 ns (Step S109).

Next, it is searched whether or not there is any cell whose function is the same as that of the cell I (Step S113). The result of the searching is shown in FIG.8. As shown in FIG.8, there are four types of cells whose function is the same as that of the cell I and there are two cells I2 and I3 whose driving ability is higher than that of the cell I (Step S114).

Accordingly, we assume that the cell I is replaced with the cell I3 (Step S115). When the cell I3 is replaced with the VDDL cell, although the delay time is increased by 1.33 ns, it can be sized up (be in up-sized) and driving ability of the replaced cell becomes higher. That is the signal arrival time to the node n16 becomes 0.17 ns (5.00 - 4.83 =0.17 ns) that is earlier before it is replaced. That is, the cell I is replaced with the VDDL cell because the timing constraints can be satisfied even if the cell I3 is replaced with the VDDL cell (Step S110). Because the cell I is not connected to the input terminal as the input pin, the cell G can be replaced with the VDDL (Step S111 and S112).

The timing slack value to the node n12 becomes 1.29 ns ((1.12 - (4.83 - 5.00)) = 1.29 ns) because the cell I is replaced with the VDDL cell (Step S106 and Step S107). Since there is the timing slack adequately, the cell G is replaced with the VDDL cell (Step S108). When the cell G is replaced with the VDDL cell, the delay of the node n10 to the node n12 is changed from 0.20 ns to 0.28 ns. This causes to increase the delay time by 0.08 ns. Because the current timing slack value becomes 1.29 ns, the timing constraints can be satisfied even if the cell I3 is replaced with the VDDL cell. Therefore the cell G can be replaced with the VDDL cell (Step S109 and Step S110).

Because the cell E connected to the input signal to be transferred to the cell G is not the input terminal as an input pin, the cell E is replaced with the VDDL cell (Step S111 and Step S112). The timing slack value becomes 1.29 ns when the cell E is replaced with the VDDL cell. Because there is the timing slack adequately, the cell E is replaced with the VDDL cell (Step S106 and Step S107). When the cell E is replaced with the VDDL cell, the delay time is increased by 0.11 ns because the delay of the node n4 to the node n10 becomes from 0.30 ns to 0.41 ns. However, since the timing slack value is 1.18 ns (1.29 ns - 0.11 ns = 1.18 ns), the timing slack can be satisfied adequately. Thereby, the cell E can be replaced with the VDDL cell (Step S109 and Step S110).

Next, the cell C connected to the input terminal of the cell E is not an input terminal as an input pin, the cell C is replaced with the VDDL cell (Step S112). Because the timing slack value is 1.18 ns and there is the timing slack adequately, the delay time is calculated when the cell C is replaced with the VDDL cell (Step S108).

As shown in FIG.7, when the cell C is replaced with the VDDL cell, the delay of the node n1 to n4 is increased by 0.38 ns from the 1.00 ns to 1.38 ns. According to this increasing, the timing slack value becomes 1.80 ns ((1.18 - 0.38) = 0.80 ns). However, because this state satisfies the timing constraints, the cell C is replaced with the VDDL cell (Step S111 and S112). Although the timing slack value becomes 0.80 ns by replacing the cell C with the VDDL cell, it is seen that the timing constraints can be adequately satisfied (Step S106 and S107). As shown in FIG.7, when the cell A is replaced with the VDDL cell, the delay time of the input terminal to the node n1 is increased from 0.45 ns to 0.63 ns. But, because the increasing of the delay time is smaller than the clack, the cell A can be replaced with the VDDL cell (Step S108, Step S109 and Step S110).

Since the input side of the cell A is directly connected to the input terminal as the input pin, the process of VDDL cell replacement operation for the path comprising the cell A --> the cell C --> the cell E --> the cell G --> the cell I --> and the cell J has been completed.

Next, the step S101 is executed in order to process the total timing analysis again. Next, paths, which have not been performed by using the low power consumption circuit design method described above, that is, in which no cell is replaced with the VDDL cell, for example, the path from the cell J to the cell D, is extracted and executed by using the process described above.

Fourth embodiment

Next, the example to replace many cells in a critical path in timing with low voltage cells will be explained with reference to the circuit diagram shown in FIG.6. In this fourth embodiment, the cells in the critical path is sized up in advance by applying the process of the first embodiment.

FIG.7 is a diagram showing an example the data items of the cell library to be used for the logic circuit shown in FIG.6. FIG.8 is a diagram showing an example of the cell library to be used for the logic circuit shown in FIG.6.

For brevity, the library data items of cells shown in FIGs.7 and 8 are used, and the timing constraints is 10.00 ns, the VDDs and the threshold value are the same as those of the first embodiment, that is, VDDH = 5 V, VDDL = 4 V, and Vth = 0.8 V. In addition, we assume that the value of the timing constraints is 10.00 ns.

In the circuit shown in FIG. 6, especially, the delay time in the cell I (that is, the delay time from the node n12 to the node n15) is 5.00 ns. This is 59.9 percent of the total delay time of the path. Although the cell I is close to the output terminal, the cell that is adjacent to the output terminal is firstly replaced to the VDDL cell in the low power consumption circuit design method of the present invention and the cell next to this cell adjacent to the output terminal is then replaced in order. Accordingly, in this case, it is difficult to replace the eight cells A, B, C, D, E, F, G, and H that are connected to the cell I with the VDDL cells. Therefore, it is difficult to reduce the power consumption of the logic circuit shown in FIG.6 effectively.

On the contrary, when the cell I can be replaced with the VDDL cell, these cells connected to the cell I can be replaced. This causes to reduce the total power consumption of the logic circuit effectively.

In the logic circuit shown in FIG.6, the path comprising the cell A --> the cell C --> the cell E --> the cell G --> the cell I --> and --> the cell J is the critical path and its delay time is 8.35 ns.

Therefore, its timing slack value is 1.65 ns (10.00 ns - 8.35 ns = 1.65 ns). In this path, the transfer delay time of the cells other than the cell I becomes 3.35 ns (8.35 ns - 5.00 ns = 3.35 ns).

The total timing slack value when all of the cells are replaced with the VDDL cells becomes 4.62 ns according to the equation [1] (1.38 × 3.35 ns = 4.62 ns). Therefore the timing constraints can be satisfied, even if the cell I is replaced with the VDDL cell, when the delay of the cell I is not more than 3.898 ns ((10.00 - 4.62) ÷ 1.38 = 3.898 ns). The total delay time becomes 6.90 ns when the cell I is replaced with the VDDL cell because the delay of the cell I is 5.00 ns. This exceeds the timing constraints. Accordingly, in the fourth embodiment, the size of the cell I is increased and then replaced with the VDDL cell.

Firstly, it is checked whether or not there is a cell in the cell library shown in FIG.8 whose operation speed is higher than that of the cell I, specifically, higher than 3.90 ns. In the library data items shown in FIG.8, there are cells whose function is the same as that of the cell I and whose operation speeds are 4.00 ns and 3.50 ns.

In this case, the cell I3 is selected in the library data items shown in FIG.8. Further, the cell I3 is replaced with the VDDL cell. Although its delay time becomes 4.83 ns (3.50 ns × 1.38 = 4.83 ns), the total delay time of the path becomes 9.45 ns (4.62 ns + 4.83 ns = 9.45 ns < 10.00 ns). This satisfies the timing constraints (10.00 ns) adequately.

In the prior art, only two cells J and K are replaced with the VDDL cells. On the contrary, it is possible to replace all of the eleven cells in the logic circuit with the VDDL cells because the cell I can be replaced with the VDDL cell. Therefore, the low power consumption circuit design method of the present invention can be applied effectively to the field to reduce the power consumption of logic circuits.

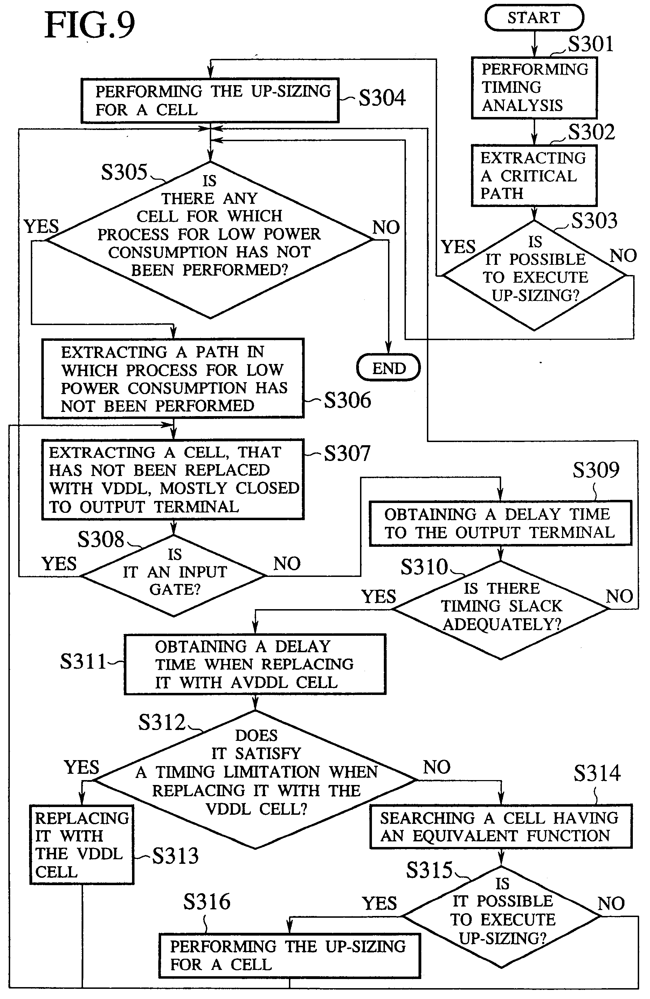

FIG.9 is a diagram showing a flow chart of the process of the low power consumption design method for logic circuits according to the fourth embodiment of the present invention. Hereinafter, the process of the fourth embodiment will be explained by using the flow chart shown in FIG.9, the logic circuit shown in FIG.6, and the library data items shown in FIG.8.

Firstly, the timing analysis of the logic circuit shown in FIG.6 is executed to confirm the signal arrival time at each node (Step S301).

The critical cell I in timing is extracted or selected based on the result of the timing analysis performed at Step S301, it is searched whether or not the size of the cell I may be increased (that is, whether the cell I is replaced with a cell whose driving ability is higher than that of the cell I or not) (Step S302 and Step S303). FIG.8 shows the result of searching. According to the result shown in FIG.8, there are four kinds of cells whose function is equal to the function of the cell I and there are the two cells I2 and I3 whose driving ability is higher than that of the cell I. Therefore we assume that the cell I is replaced with the cell I3. Although the delay time is increased by 1.33 ns when the cell I3 is replaced with the VDDL cell, the signal arrival time to the node n16 is decreased by 0.17 ns because the size of the cell I3 is larger than that of the cell I and the driving ability of the cell I3 is higher than that of the cell I. This signal arrival time to the node n16 is smaller than that of the case before the replacement. Therefore it is determined that the cell I can be replaced with the cell I3 (Step S304).

Next, the low power processing is applied to each path. At this time, any path can be selected because no processing is performed. Firstly, the critical path comprising the cell A --> the cell C --> the cell E --> the cell G --> the cell I --> and the cell J is extracted (Step S305 and Step S306).

Because the example of the fourth embodiment has the configuration in which the VDDH cluster is formed at the input side and the VDDL cluster is formed at the output side, the cell close to the output terminal is replaced with the VDDL cell. At first, the cell J is replaced with the VDDL cell (Step S307). Because the cell J is not the input cell, it is possible to replace it with the VDDL cell (Step S308). Because the signal arrival time to the node 20 is 6.85 ns, the timing slack value becomes 3.15 ns (Step S309). Because there is the timing slack adequately, the delay time of the case in which the cell J is replaced with the cell VDDL is calculated (Step S310).

As shown in FIG.7, when the cell J is replaced with the VDDL cell, the delay time from the node n16 to the node n20 is changed from the 1.40 ns to 1.93 ns and the timing slack value becomes 2.62 ns ((3.15 - (1.93 - 1.40)) = 2.62 ns). It is seen that this replacement satisfies the timing constraints. Accordingly, the cell J can be replaced with the VDDL cell (Step S311 and Step S312).

Because the cell J is not connected to the input pins I0 to I7 as the input terminals, the cell I3, whose size is increased in Step S304 and that is close to the input terminal only by one when comparing to the cell J, is replaced with the VDDL cell.

The timing slack value at the node n16 is 2.62 ns based on the result of the timing analysis (Step S309). There is the timing slack adequately (Step S310), the delay time is calculated when the cell I3 is replaced with the VDDL cell (Step S311). As shown in FIG.8, the delay time from the node n12 to the node n16 is increased by 1.33 ns (4.83 - 3.50 = 1.33 ns) when the cell I3 is replaced with the VDDL cell. Because the result of this replacement satisfies the timing constraints (Step S312), the cell I3 is replaced with the VDDL cell (Step S313).

Next, because the cell I is not connected to the input pin, the cell G is replaced with the VDDL cell (Step S307 and Step S308).

The timing slack value to the node n12 is 1.29 ns (2.62 - 1.33 = 1.29 ns) (Step 309). Because there is the timing slack adequately, the cell G is replaced with the VDDL (Step S311). When the cell G is replaced with the VDDL cell, the delay time from the node n10 to the node n12 is changed from 0.20 ns to 0.28 ns. Thus, the delay time is increased by 0.08 ns. Because the current timing slack value is 1.29 ns, the replacement of the cell G with the VDDL cell satisfies the timing constraints. Accordingly, it is possible to replace the cell G with the VDDL cell (Step S312 and Step 313).

Because the cell E connected to the cell G is not the input pin (Step S308), there is a possibility to replace the cell E with the VDDL cell (Step S309). There is the timing slack adequately (Step S310), therefore, the cell E is replaced with the VDDL cell. When the cell E is replaced with the VDDL cell, the delay time from the node n4 to the node n10 is changed from 0.30 ns to 0.41 ns. Thereby, the delay time is increased by 0.11 ns. Because the current timing slack value is 1.18 ns (1.29 ns - 0.11 ns = 1.18 ns), the replacement of the cell E with the VDDL cell satisfies the timing constraints. Accordingly, it is possible to replace the cell E with the VDDL cell (Step 313).

Next, the cell C connected to the cell E is not also the input pin (Step S307 and Step S308), there is a possibility to replace the cell C with the VDDL cell. Because the timing slack value is 1.18 ns (Step S309) and there is the timing adequately (Step S310), the delay time is calculated when the cell C is replaced with the VDDL cell (Step S311). When the cell C is replaced with the VDDL cell according to the data item in the cell library shown in FIG.7, the delay time from the node n1 to the node n4 is changed from 1.00 ns to 1.38 ns. Thus, the delay time is increased by 0.38 ns. Because the current timing slack value is 0.80 ns (1.18 ns - 0.38 ns = 0.80 ns), the replacement of the cell C with the VDDL cell satisfies the timing constraints (Step S312). Accordingly, it is possible to replace the cell C with the VDDL cell (Step 313).

Next, the cell A connected to the cell C is not the input pin (Step S307 and Step S308), the cell A is replaced with the VDDL cell. Although the current timing slack value is 0.80 ns by replacing the cell C with the VDDL cell, there is the timing slack adequately (Step S309 and Step S310). According to the data item in the cell library shown in FIG.7, when the cell A is replaced with the VDDL cell, the delay time from the input pin to the node n1 is changed from 0.45 ns to 0.62 ns. Thus, the delay time is smaller than the current timing slack value, the cell A can be replaced with the VDDL cell (Step S311 and Step S312). Accordingly, the cell A is replaced with the VDDL cell (Step 313).

Because the input terminal of the cell A is directly connected to the input pin of the logic circuit, the operation of the replacement with the VDDL cells for the path comprising the cell A --> the cell C --> the cell E --> the cell G --> the cell I --> and the cell J has been completed.

Next, the operation of Step S301 will be performed. In Step S301, the timing analysis for the entire circuit is performed again. Next, paths where no replacement with the VDDL cell have been executed (for example, the path from the cell J to the cell D) are extracted, and the process described above is repeated for these extracted paths.

Fifth embodiment

In the fifth embodiment, an example will now be explained. In the example, many cells can be replaced with the VDDL cells by sizing up the bottle-necked cell in area with reference to FIG.6. This bottle-necked cell is on a critical path described in the process of the first embodiment.

FIG.7 is the table showing the data items in the cell library in the logic circuit shown in FIG.6.

For brevity, in the fifth embodiment, the timing constraints value is 10.00 ns. The VDD and the threshold value are the same as those of the first embodiment (That is, the VDDH = 5.0 V, VDDL = 4.0 V, and Vth = 0.8 V). The timing constraints value is 10 ns.

In the logic circuit shown in FIG.6, the critical path is the path comprising the cell A --> the cell C --> the cell E --> the cell G --> the cell I --> and the cell J. The delay time of this path is 8.35 ns. In this critical path, the delay time from the node n12 to the node n15 in this critical path is 5.00 ns (the transfer delay of the cell I). This delay time is 59.9 percent of the total delay time of the path 8.35 ns.

Because the cell I is close to the output terminal, the cells near to the output terminal are replaced with the VDDL cells in order in the fifth embodiment. The cell I connected to the eighth cells A, B, C, D, E, F, G, and H can not be replaced with the VDDL cells.

Accordingly, the power consumption of the logic circuit shown in FIG.6 can not be reduced greatly. On the contrary, when the cell I can be replaced with the VDDL cell, these cells connected to the cell I can also be replaced with the VDDL cells. This causes to reduce the power consumption of the logic circuit shown in FIG.6 greatly.

The current timing slack value of the logic circuit shown in FIG.6 is 1.65 ns (10.00 ns - 8.35 ns = 1.65 ns). The total delay time other than the cell I is 3.35 ns (8.35 ns - 5.00 ns = 3.35 ns). The total timing slack value of the case in which all of the cells are replaced with the VDDL cells is 4.62 ns ($1.38 \times 3.35$ ns = 4.62 ns) by the equation [1]. Accordingly, if the transfer delay of the cell I is not more than 3.898 ns ((10.00 - 4.62) ÷ 1.38 = 3.898 ns), the replacement of the cell I with the VDDL cell can satisfy the timing constraints. However, the delay time becomes 6.90 ns when the cell I is replaced with the VDDL cell because the transfer delay time of the cell I is 5.00 ns. This causes to over the timing constraints only by the replacement of the cell I with the VDDL cell.

Next, it is checked the absence of cells, in the library data items shown in FIG.8, whose operation speed is higher than that of the cell I. In the library data items shown in FIG.8, there are cells whose function is the same as that of the cell I and whose operation speeds are 4.00 ns and 3.50 ns, respectively. In this embodiment, the cell I3 whose delay time is 3.50 ns is selected. The delay time becomes 4.83 ns when the cell I3 is replaced with the VDDL cell. The total delay time of the path becomes 9.45 ns (4.62 ns + 4.83 ns = 9.45 ns). This satisfies the timing constraints because 9.45 ns < 10.00 ns.

According to the fifth embodiment, all of eleven cells in the critical path can be replaced with the VDDL cells by replacing the cell I with the VDDL cell. On the contrary, only two cells such as the cell J and the cell K can be replaced with the VDDL cells in the prior art.

This means that the power consumption of a logic circuit can be effectively reduced according to the low power consumption circuit design method of the fifth embodiment according to the present invention.

Sixth embodiment

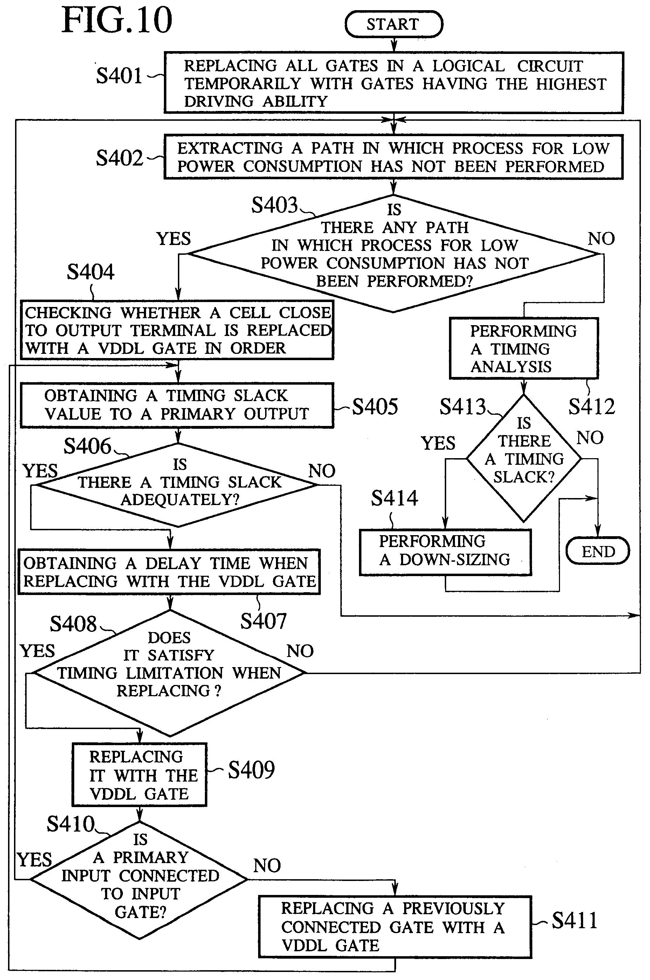

FIG.10 is a diagram showing a flow chart of the process of a low power consumption circuit design method for logic circuits according to the fifth embodiment of the present invention.

The process flow of the sixth embodiment will now be explained by using the logic circuit shown in FIG.2 and the library data items shown in FIG.3

For brevity, the timing constraints is 14.00 ns. The VDD and the threshold value are the same as those of the first embodiment (that is, the VDDH = 5.0 V, the VDDL = 4.0 V, and Vth = 0.8 V). The timing constraints value is 10 ns.

Firstly, all of the cells connected to a path are replaced with cells whose driving ability are higher, respectively. In this replacement process, for example, the cells G1 to G4 are replaced as follows: the cell G1 --> the cell G1, the cell G2 --> the cell G24, the cell G3 --> the cell G33, and the cell G4 --> the cellI G4 (Step S401).

Next, a path where no replacement operation of cells has been performed to reduce the power consumption, for example, the path connecting the cells G1 to G4 is extracted. The cell close to the output terminal is replaced with the VDDL cell in order (Step S402 and Step S403). Firstly, the timing slack value to the node n5 is calculated (Step S405). The delay time from the input pin to the output pin becomes 10.67 ns (5.00 + 1.85 + 0.82 + 3 = 10.67 ns) and the timing slack value becomes 3.33 ns by the definition.

Because there is the timing slack adequately, the cell G4 is replaced with the VDDL cell (Step S406). The delay time is increased by 1.90 ns when the cell G4 is replaced with the VDDL cell. This replacement satisfies the timing constraints. Accordingly, the cell G4 can be replaced with the VDDL cell (Step S407 to Step S409).

Next, it is checked whether or not the cell G33 can be replaced with the VDDL cell. When the timing slack value is calculated (Step S405), although the timing slack value at the node n4 is decreased to 1.43 ns, there is the timing slack adequately. The timing slack value is calculated when the cell G33 is replaced with the VDDL cell. According to the timing slack value, the delay time is increased by 0.70 ns (change from 1.85 ns to 2.55 ns). Because the timing slack value is 1.43 ns, the margin of the timing delay is 0.73 ns (1.43 - 0.70 = 0.73 ns). Accordingly, the cell G33 can be replaced with the VDDL cell (Step S409).

Next, it is checked whether or not the cell G24 can be replaced with the VDDL cell. The following timing slack value is obtained as the result of the calculation of the timing slack value (Step S405): The timing slack value at the node n2 is 0.73 ns. This means that there is the timing slack adequately (Step S406). The delay time is changed from 0.60 ns to 0.82 ns when the cell G24 is replaced with the VDDL cell, namely, the delay time is increased by 0.22 ns. However, there is the timing slack of 0.51 ns (0.73 - 0.22 = 0.51 ns) even if the cell G24 is replaced with the VDDL cell. Accordingly, the cell G24 is replaced with the VDDL cell (Step S409).

Finally, it is checked whether or not the cell G1 can be replaced with the VDDL cell. According to the result of analysis of the timing slack value (Step S405), it is seen that there is the timing slack adequately because the timing slack value at the node n1 is 0.51 ns.

Next, it is performed to check the change of the timing slack value when the cell G1 is replaced with the VDDL cell (Step S407 and Step 408). It is detected that the delay is increased by 1.90 ns from 5.00 ns to 6.90 ns. Accordingly, the processing of the replacement to the VDDL cells in the path comprising the cells G1 to G4 has been completed because the replacement of the cell G1 with the VDDL cell can not satisfy the timing constraints.

The low power consumption process for the path comprising the cells G5 and G6 can be performed like the process for the path including the cells G1 to G4 described above. When these processing is applied to all of the paths in the logic circuit, many cells can be replaced with the VDDL cells. In addition to this, by replacing each cell having an adequate timing slack with a cell whose driving ability is lower (Step S412 to Step S414), a lot of power consumption can be reduced.

It is possible to apply the low power consumption circuit design method according to the sixth embodiment described above to logic circuits in a logical synthesis step in advance. In this case, the same effect can also be obtained.

As described above, according to the sixth embodiment, a timing slack can be generated and cells can be further replaced with cells performing under a lower voltage power source by replacing cells (which are not replaced with cells of the lower voltage power source in the prior art because the cells do not satisfy the timing constraints and the cells are not target cells for a gate resizing process) with cells of higher driving ability. Accordingly, because the operation voltage for cells in other paths in addition to the critical path can be reduced, it is possible to reduce the power consumption of a LSI greatly.

In summary, as described above in detail, according to the low power consumption circuit design method of the present invention, it is possible to reduce the power consumption of a LSI greatly by replacing cells (which are not replaced with cells of the lower voltage power source in the prior art because these cells do not satisfy the timing constraints and these cells are not target cells for a gate resizing process) with cells performing under a lower voltage power source.

While the above provides a full and complete disclosure of the preferred embodiments of the present invention, various modifications, alternate constructions and equivalents may be employed without departing from the true spirit and scope of the invention. Therefore the above description and illustration should not be construed as limiting the scope of the invention, which is defined by the appended claims.

## Claims

1. A low power consumption circuit design method for a LSI comprising logic circuits including cells that operate under at least two different voltage power sources, comprising the steps of:

    a timing analysis step of performing a timing analysis for the cells in the logic circuits in the LSI;
    a conversion step of converting an optional cell in the cells into a cell having a different driving ability; and
    a replacement step of replacing the optional cell with a cell that operates under a different voltage power source.

2. A low power consumption circuit design method as claimed in claim 1, wherein

    the timing analysis step comprises:

    an extraction step of extracting a path in the logic circuits in which there is no timing slack in timing, the conversion step comprises:
    a step of replacing the optional cell with a cell having an equivalent function and a higher driving ability, and

    the low power consumption circuit design method further comprises:

    a step of converting the optional cell with a cell that satisfies a required timing constraints and operates under a lower voltage power source.

3. A low power consumption circuit design method as claimed in claim 2, wherein

    in the step of extracting the path having no timing slack and in the step of replacing the optional cell with cell having the different driving ability in the timing analysis step, the optional cell is replacing with a cell, having the equivalent function and a higher driving ability, that is operable under a lower voltage power source within satisfying of the timing constraints.

4. A low power consumption circuit design method as claimed in claim 2, wherein

    the step of replacing the optional cell with a cell having the different driving ability in the timing analysis step further comprises a step of replacing the optional cell with a cell having a smaller driving ability.

5. A low power consumption circuit design method as claimed in claim 4, wherein

    in the step of replacing the optional cell with the cell having the different driving ability, the optional cell is replacing with a cell having an equivalent function and a higher driving ability, and then replacing it with a cell that is operable under a lower voltage power source, and
    in the step of replacing the optional cell with the cell having the different driving ability with keeping of the timing constraints in accordance with a result of the timing analysis step, the optional cell is replacing with a cell having a lower driving ability.

6. A low power consumption circuit design method for a LSI comprising logic circuits including cells that operate under at least two different voltage power sources, comprising the steps of:

   a timing analysis step of performing a timing analysis for the logic circuits in the LSI;
   a step of obtaining a delay time for a cell connected to a path having a timing slack in the logic circuits in accordance with a result of the timing analysis step, and of replacing the cell with a cell that is operable under a lower voltage power source only when this replaced cell satisfies a timing constraints; and
   a step of replacing a cell connected to a path having no timing slack with a cell having an equivalent function and a higher driving ability in accordance with a result of the timing analysis step, and of further replacing the cell with a cell that is operable under the lower voltage power source when this replacement satisfies the timing constraints.

7. A low power consumption circuit design method for a LSI comprising logic circuits including cells that operate under at least two different voltages power sources, comprising the steps of:

   a timing analysis step of performing a timing analysis for the logic circuits in the LSI;
   a step of obtaining a delay time for a cell connected to a path having a timing slack in the logic circuits in accordance with a result of the timing analysis step, and of replacing the cell with a cell that is operable under a lower voltage power source only when this replaced cell satisfies a timing constraints;
   a step of replacing a cell connected to a path having no timing slack with a cell having an equivalent function and a higher driving ability in accordance with a result of the timing analysis step, and of replacing the cell with a cell that is operable under the lower voltage power source when this replacement satisfies the timing constraints; and
   a step of replacing the cell, connected to the path having a timing slack in accordance with the result of the timing analysis step, with a cell having the equivalent function and a higher driving ability when the replacement of this cell with the cell being operable under the lower voltage power source does not satisfy the timing constraints, and of further replacing this cell with a cell that is operable under the lower voltage power source when this replacement satisfies the timing constraints.

8. A low power consumption circuit design method as claimed in claim 7, wherein

   when it does not satisfy the timing constraints that the cell connected to the path having the timing slack in the logic circuits is replaced with the cell that being operable under the lower voltage power source in accordance with the result of the timing analysis step, further comprises the steps of:

   a step of searching whether or not there is a cell having the equivalent function and a higher driving ability for the cell that has already been replaced with the cell that being operable under the lower voltage power source;
   a step of replacing the searched cell with a cell having the equivalent function and the higher driving ability; and
   a step of further replacing the replaced cell with a cell that being operable under the lower voltage power source when this replacement satisfies the timing constraints.

# FIG.1

START

S101 — PERFORMING TIMING ANALYSIS AND CHECKING A SIGNAL ARRIVAL TIME AT EACH NODE

S102 — CHECKING A PATH IN WHICH PROCESS FOR LOW POWER CONSUMPTION HAS NOT BEEN PERFORMED

S103 — IS THERE ANY PATH IN WHICH PROCESS FOR LOW POWER CONSUMPTION HAS NOT BEEN PERFORMED?

YES / NO

NO → END

S104 — EXTRACTING A PATH

S105 — CHECKING WHETHER A CELL CLOSE TO OUTPUT TERMINAL IS REPLACED WITH A VDDL GATE IN ORDER

S106 — OBTAINING A TIMING SLACK VALUE TO A PRIMARY OUTPUT

S107 — IS THERE A TIMING SLACK ADEQUATELY?

YES / NO

NO → SEARCHING A GATE HAVING AN EQUIVALENT FUNCTION

S108 — OBTAINING A DELAY TIME WHEN REPLACING WITH THE VDDL GATE

S109 — DOES IT SATISFY TIMING LIMITATION WHEN REPLACING THE VDDL GATE?

YES / NO

S113 — S114 — IS THERE ANY GATE HAVING A HIGHER DRIVING ABILITY?

YES / NO

S110 — REPLACING IT WITH THE VDDL GATE

S115 — REPLACING IT TEMPORARILY WITH THE GATE HAVING THE HIGHER DRIVING ABILITY

S111 — IS A PRIMARY INPUT CONNECTED TO INPUT GATE?

YES / NO

S112 — REPLACING A PREVIOUSLY CONNECTED GATE WITH A VDDL GATE

# FIG.2

INPUT
TERMINALS

OUTPUT
TERMINALS

I1

I2

G1

n1

G2

n2

G3

o1

o2

n4

I3

I4

I5

G5

n6

n7

n3

G6

G4

n5

o3

n8

I6

I7

o4

EP 0 827 097 A2

## FIG.3

| DIFFERENCE OF DELAY TIME BEFORE AND AFTER REPLACEMENT | 1.90 | 2.28 | - | - |
|---|---|---|---|---|
| VDDL | 6.90 | 8.28 | - | - |
| VDDH | 5.00 | 6.00 | - | - |
| CELL'S NAME | G4 | G42 | - | - |

| DIFFERENCE OF DELAY TIME BEFORE AND AFTER REPLACEMENT | 0.76 | 0.95 | 0.63 | - |
|---|---|---|---|---|
| VDDL | 2.76 | 3.45 | 2.28 | - |
| VDDH | 2.00 | 2.50 | 1.65 | - |
| CELL'S NAME | G3 | G32 | G33 | - |

| DIFFERENCE OF DELAY TIME BEFORE AND AFTER REPLACEMENT | 0.38 | 0.45 | 0.32 | 0.22 |
|---|---|---|---|---|
| VDDL | 1.38 | 1.65 | 1.17 | 0.82 |
| VDDH | 1.00 | 1.20 | 0.85 | 0.6 |
| CELL'S NAME | G2 | G22 | G23 | G24 |

| DIFFERENCE OF DELAY TIME BEFORE AND AFTER REPLACEMENT | 1.52 | 1.14 | - | - |
|---|---|---|---|---|
| VDDL | 5.52 | 4.14 | - | - |
| VDDH | 4.00 | 3.00 | - | - |
| CELL'S NAME | G1 | G12 | - | - |

# FIG.4

| CELL'S NAME | TIMING SLACK | DELAY OF CELL | DELAY TIME AFTER REPLACEMENT | DIFFERENCE OF DELAY TIME BEFORE AND AFTER REPLACEMENT | TIMING SLACK AFTER REPLACEMENT |
|---|---|---|---|---|---|
| G4 | 3.00 | 5.00 | 6.90 | 1.90 | 1.10 |
| G3 | 1.10 | 2.00 | 2.76 | 0.76 | 0.34 |
| G2 | 0.34 | 1.00 | 1.38 | 0.38 | -0.04 |
| G1 | -0.04 | 4.00 | 5.52 | | |

EP 0 827 097 A2

# FIG.5

START

S201 — PERFORMING TIMING ANALYSIS AND CHECKING A SIGNAL ARRIVAL TIME AT EACH NODE

S202 — CHECKING A PATH IN WHICH PROCESS FOR LOW POWER CONSUMPTION HAS NOT BEEN PERFORMED

S203 — IS THERE ANY PATH IN WHICH PROCESS FOR LOW POWER CONSUMPTION HAS NOT BEEN PERFORMED?

YES

NO → END

S204 — EXTRACTING A PATH

S205 — CHECKING WHETHER A CELL CLOSE TO OUTPUT TERMINAL IS REPLACED WITH A VDDL GATE IN ORDER

S206 — OBTAINING A TIMING SLACK VALUE TO A PRIMARY OUTPUT

S207 — IS THERE A TIMING SLACK ADEQUATELY?

YES

NO

SEARCHING A GATE HAVING AN EQUIVALENT FUNCTION — S213

S214 — IS THERE ANY GATE HAVING A HIGHER DRIVING ABILITY?

YES

NO

S208 — OBTAINING A DELAY TIME WHEN REPLACING WITH THE VDDL GATE

S209 — DOES IT SATISFY TIMING LIMITATION WHEN REPLACING THE VDDL GATE?

YES

NO

REPLACING IT TEMPORARILY WITH THE GATE HAVING THE HIGHER DRIVING ABILITY — S215

S210 — REPLACING IT WITH THE VDDL GATE

SEARCHING A GATE THAT HAS BEEN REPLACED WITH THE VDDL GATE AND POSSIBLE TO INCREASING ITS SIZE — S216

S211 — IS A PRIMARY INPUT CONNECTED TO INPUT GATE?

YES

NO

REPLACING A PREVIOUSLY CONNECTED GATE WITH A VDDL GATE — S212

FIG.6

# FIG.7

| CELL'S NAME | VDDH | VDDL | DIFFERENCE OF DELAY TIME BEFORE AND AFTER REPLACEMENT |
|---|---|---|---|
| A | 0.45 | 0.62 | 0.18 |
| B | 0.45 | 0.62 | 0.18 |
| C | 1.00 | 1.38 | 0.38 |
| D | 0.80 | 1.25 | 0.45 |
| E | 0.30 | 0.41 | 0.11 |
| F | 0.60 | 0.83 | 0.23 |
| G | 0.40 | 0.55 | 0.15 |
| H | 0.60 | 0.83 | 0.23 |
| I | 5.00 | 6.90 | 1.90 |
| J | 1.40 | 1.93 | 0.53 |
| K | 1.20 | 1.66 | 0.46 |

# FIG.8

| CELL'S NAME | VDDH | VDDL | DIFFERENCE OF DELAY TIME BEFORE AND AFTER REPLACEMENT |
|---|---|---|---|
| I | 5.00 | 6.90 | 1.90 |
| I2 | 4.00 | 5.52 | 1.52 |
| I3 | 3.50 | 4.83 | 1.33 |
| I4 | 5.50 | 7.59 | 2.09 |

# FIG.9

START

S301

PERFORMING
TIMING
ANALYSIS

S302

EXTRACTING
A CRITICAL
PATH

S303

IS
IT POSSIBLE
TO EXECUTE
UP-SIZING?
YES        NO

PERFORMING THE UP-SIZING
FOR A CELL — S304

S305
IS
THERE ANY
CELL FOR WHICH
PROCESS FOR LOW POWER
CONSUMPTION HAS NOT
BEEN PERFORMED?
YES                    NO

END

EXTRACTING A PATH IN
WHICH PROCESS FOR LOW
POWER CONSUMPTION HAS
NOT BEEN PERFORMED — S306

EXTRACTING A CELL, THAT — S307
HAS NOT BEEN REPLACED
WITH VDDL, MOSTLY CLOSED
TO OUTPUT TERMINAL

S308
IS
IT AN INPUT
GATE?
YES              NO

S309
OBTAINING A DELAY TIME
TO THE OUTPUT TERMINAL

S310
IS THERE
TIMING SLACK
ADEQUATELY?
YES                    NO

OBTAINING A DELAY
TIME WHEN REPLACING
IT WITH AVDDL CELL
S311

S312
DOES
IT SATISFY
A TIMING LIMITATION WHEN
REPLACING IT WITH THE
VDDL CELL?
YES                    NO          S314

REPLACING
IT WITH
THE VDDL
CELL — S313

SEARCHING A CELL HAVING
AN EQUIVALENT FUNCTION

S315
IS
IT POSSIBLE
TO EXECUTE
UP-SIZING?
YES                    NO

S316

PERFORMING THE UP-SIZING
FOR A CELL

# FIG.10

START

S401 — REPLACING ALL GATES IN A LOGICAL CIRCUIT TEMPORARILY WITH GATES HAVING THE HIGHEST DRIVING ABILITY

S402 — EXTRACTING A PATH IN WHICH PROCESS FOR LOW POWER CONSUMPTION HAS NOT BEEN PERFORMED

S403 — IS THERE ANY PATH IN WHICH PROCESS FOR LOW POWER CONSUMPTION HAS NOT BEEN PERFORMED?

YES

NO

S404 — CHECKING WHETHER A CELL CLOSE TO OUTPUT TERMINAL IS REPLACED WITH A VDDL GATE IN ORDER

PERFORMING A TIMING ANALYSIS

OBTAINING A TIMING SLACK VALUE TO A PRIMARY OUTPUT — S405

S413 — IS THERE A TIMING SLACK? S412

S406 — IS THERE A TIMING SLACK ADEQUATELY?

YES

NO

YES

NO

S414 — PERFORMING A DOWN-SIZING

END

OBTAINING A DELAY TIME WHEN REPLACING WITH THE VDDL GATE

S408 — DOES IT SATISFY TIMING LIMITATION WHEN REPLACING ? S407

YES

NO

REPLACING IT WITH THE VDDL GATE — S409

S410 — IS A PRIMARY INPUT CONNECTED TO INPUT GATE?

YES

NO

REPLACING A PREVIOUSLY CONNECTED GATE WITH A VDDL GATE — S411

# FIG.11
## PRIOR ART

INPUT TERMINALS

VDDH CLUSTER

VDDL CLUSTER

OUTPUT TERMINALS

i1

i2

i3

i4

i5

LC — o1

LC — o2

LC — o3

LC — o4

EP 0 827 097 A2